Europäisches Patentamt

European Patent Office

Office européen des brevets

(19)

(11) EP 0 565 806 B1

(12) **EUROPEAN PATENT SPECIFICATION**

(45) Date of publication and mention
of the grant of the patent:
**28.08.1996 Bulletin 1996/35**

(51) Int Cl.[6]: **G05F 3/24**

(21) Application number: **92830187.8**

(22) Date of filing: **16.04.1992**

(54) **Accurate MOS threshold voltage generator**

Genauer MOS-Schwellenspannungsgenerator

Générateur précis de tension de seuil de MOS

(84) Designated Contracting States:
**DE FR GB IT**

(43) Date of publication of application:
**20.10.1993 Bulletin 1993/42**

(73) Proprietor: **SGS-THOMSON
MICROELECTRONICS S.r.l.
I-20041 Agrate Brianza (Milano) (IT)**

(72) Inventors:
• **Alini, Roberto
I-27049 Stradella, Pavia (IT)**
• **Baschirotto, Andrea
I-15057 Tortona, Alessandria (IT)**
• **Castello, Rinaldo
I-20043 Arcore, Milano (IT)**
• **Portaluri, Salvatore
I-27100 Pavia (IT)**

(74) Representative: **Checcacci, Giorgio
PORTA, CHECCACCI & BOTTI s.r.l.
Viale Sabotino, 19/2
I-20135 Milano (IT)**

(56) References cited:
**GB-A- 2 016 801          GB-A- 2 198 559**

• **RESEARCH DISCLOSURE no. 281, September
1987, NEW YORK, US page 572 JOHN K.
MORIARTY "FET threshold voltage generator"**
• **RESEARCH DISCLOSURE no. 281, September
1987, NEW YORK, US page 570 MARK B.
KEARNEY 'FET Threshold Voltage Dependent
Current Generator'**
• **IBM TECHNICAL DISCLOSURE BULLETIN. vol.
32, no. 9B, February 1990, NEW YORK US pages
4 - 5 'Silicon Band-Gap Reference Voltage
Generators Based on Dual Polysilicon Mos
Transistors'**
• **ELECTRONIC CIRCUITS AND SYSTEMS vol. 3,
no. 1, January 1979, pages 1 - 4 Y. P. TSIVIDIS &
R.W. ULMER "Threshold voltage generation and
supply-independent biasing in c.m.o.s.
integrated circuits" '**

## Description

This invention relates to a threshold voltage generator for a field-effect transistor.

More particularly, the invention concerns a threshold voltage generator for a MOS transistor, which is effective to compensate for variations in the threshold voltage from a nominal value.

As it is well known, threshold voltage Vth is the voltage that must be applied across the gate and source electrodes of a MOS transistor in order to have a current flown through the transistor.

This voltage is, therefore, a parameter of primary importance to the control of the operation of integrated circuits made in accordance either with the CMOS or mixed bipolar-MOS (BiMOS) technologies.

The nominal value of the threshold voltage is set by the technological process, but this value does not remain constant over time due to a number of factors, among which are: variations in some parameters of the manufacturing process; operating temperature; and ageing of the integrated circuit. These factors bring about changes which are difficult to foresee, with variations of up to 40% in the value of the threshold voltage Vth with respect to the nominal value.

To obviate this problem, the prior art has proposed a circuit approach described by Y. P. Tsividis and R. W. Ulmer in an article "Threshold voltage generation and supply-independent biasing in CMOS integrated circuits", Electronic Circuits and Systems, Vol. 3, issue No. 1, January, 1979.

That approach provides a circuit device capable of generating a voltage with a value which is an integer multiple of the threshold voltage Vth, to thereby provide an independent supply source having a desired value and adapted for use as a reference voltage to attenuate the effects from the threshold voltage variability.

While being in many ways advantageous, this prior approach falls short of solving all the problems involved in making typical integrated circuits.

Specifically, the circuit proposed by the prior art has shown serious accuracy limitations where called upon to generate threshold voltages below 0.4 Volts. Further, it has been impossible to detect threshold voltages of n-channel MOS transistors made with processes of the so-called P-well type, i.e. doping processes wherein regions of the P-well type are formed in the substrate of the semiconductor.

Likewise, the circuit is unable to detect threshold voltages of p-channel MOS's obtained with processes of the N-well type.

The technical problem that underlies this invention is to provide a threshold voltage generating circuit, particularly for MOS transistors, which has such structural and performance characteristics as to overcome the drawbacks with which the above prior approach is beset.

It is known from GB-A-2 198 559 to generate a threshold voltage from the gate-source voltages of two transistors each traversed by a given current.

These problems are solved by a voltage generator of the kind set forth above and defined in the characterizing portion of Claim 1.

The features and advantages of a threshold voltage generator according to the invention will become apparent from the following detailed description of an embodiment thereof, given by way of non-limitative example with reference to the accompanying drawings.

In the drawings:

Figure 1 is a diagramatic view of a voltage generator according to the invention;
Figure 2 is a diagram showing the generator of Figure 1 in greater detail; and

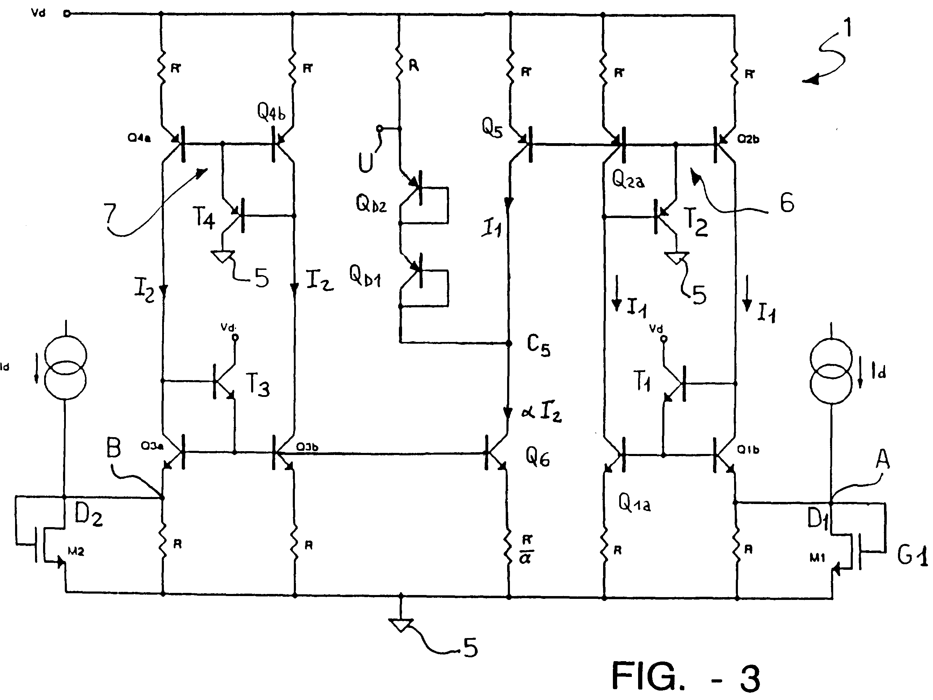

Figure 3 is a further diagram showing a modified embodiment of the generator of Figure 1.

With reference to the drawing views, generally and schematically shown at 1 is a generator of threshold voltage Vth embodying this invention and intended for supplying the gate electrode G of a transistor M of the MOS type.

This generator 1 comprises a first operational amplifier 2 having two inputs and being of the differential cell type, for example. A first A of said inputs, also referred to as the inverting (-) input, is connected with one end to a current generator Id, and with the other end, to the drain electrode D1 of a MOS transistor M1. This transistor M1 has its source S1 connected to a reference potential 5 and the gate electrode G1 connected to the drain D1.

Basically, the inverting (-) input of the amplifier 2 is connected to ground through the transistor M1 into a diode configuration.

The other input B of the amplifier 2, referred to as the non-inverting (+) input, is connected to the output of a voltage amplifier 3 having a gain value defined by a parameter α.

This second-mentioned amplifier 3 has an input connected both to a current generator Id and to a reference potential via a MOS transistor M2, which is connected in the circuit into a diode configuration and has its gate G2 and drain D2 in common and its source S2 connected to said potential 5.

The generator 1 layout is completed by a third amplifier 4 connected downstream from the first-mentioned amplifier 2 and being characterized by a gain expressed by the $1/(\alpha - 1)$ ratio.

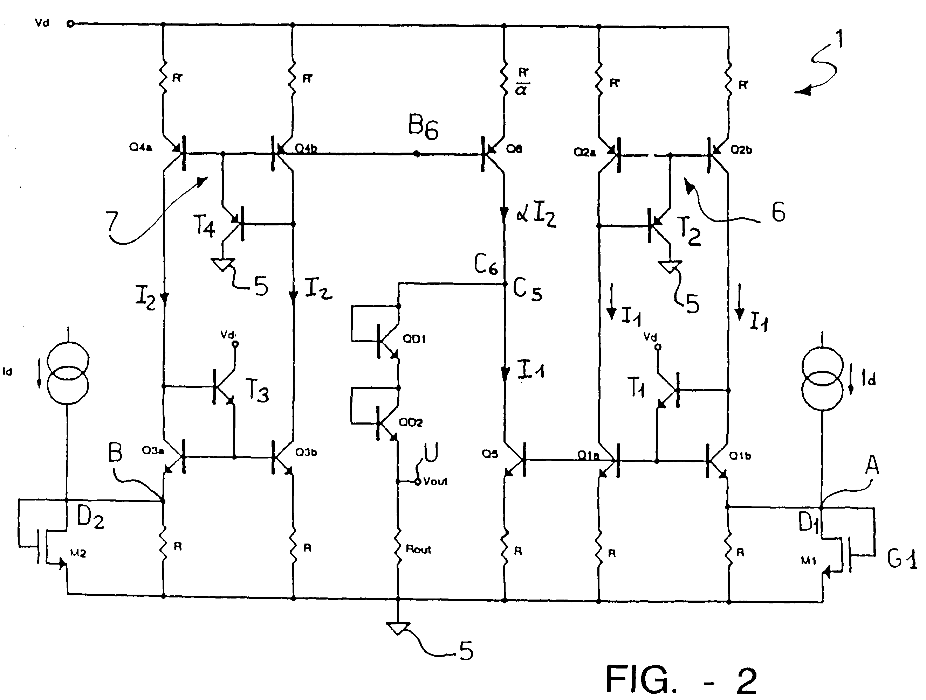

Detailed in Figure 2 is one embodiment of the generator 1 circuit.

The differential amplifier 2 is structured with a first cell comprising bipolar transistors Q1a, Q1b connected in a common-base link and, via a transistor T1, to a constant reference voltage Vd.

The emitter of transistor Q1b is indicated at A because it would coincide with the inverting input of stage 2. Connected to that input are the drain electrode D1 of the MOS transistor M1 and the corresponding current generator Id.

The differential cell also includes transistors Q2a and Q2b which make up, in combination with another transistor T2, a biasing circuit 6 configured as a current mirror.

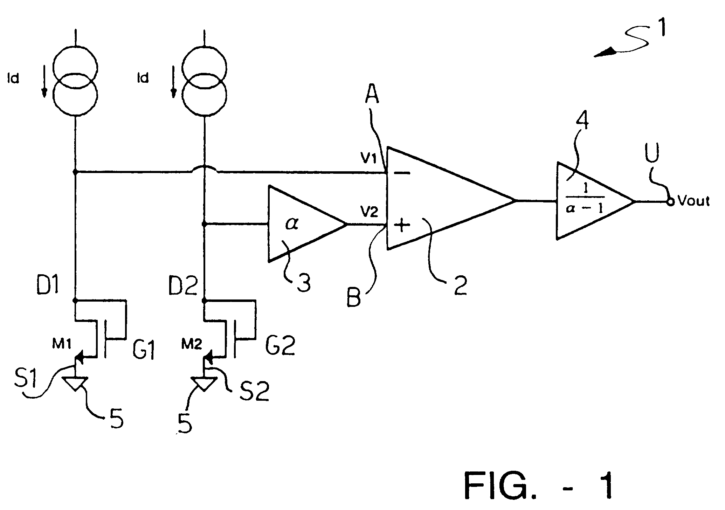

Arranged in parallel with the first-mentioned transistor pair Q1a, Q1b is a bipolar transistor Q5 of the npn type having the emitter connected to the potential 5 via a resistor R and the collector C5 in common with the collector C6 of a transistor Q6 of the pnp type. The last-named transistor Q6 corresponds essentially to the second amplifier 3 of the layout shown in Figure 1 and has its emitter connected to the reference voltage Vd via a resistor having a resistive value of $R/\alpha$.

A second cell comprises a pair of bipolar transistors Q3a, Q3b connected with their bases in common. A further transistor T3 connects these bases to the reference voltage Vd.

The emitter, indicated at B, of the transistor Q3a represents the non-inverting input of stage 2. Connected to this input are the drain D2 of the MOS transistor M2 and the other generator Id.

A current-mirror biasing circuit 7 comprises transistors Q4a, Q4b and T4 connected to the pair Q2a, Q2b as in circuit 6. The bases of transistors Q4a, Q4b are connected in common and to the base B6 of transistor Q6. Additionally, the area of transistor Q6 is $\alpha$ times as large as that of transistor Q4a.

The circuit 1 structure is completed by a pair of transistors QD1 and QD2 of the bipolar npn type which are connected serially to each other and in a diode configuration. These serve the function of ensuring an adequate collector-emitter voltage drop across transistor Q5.

The former, QD1, of these transistors has its collector in common with the collectors C5 and C6 of transistors Q5 and Q6, whilst the emitter of the latter, QD2, transistor is connected to the potential 5 via a resistor R.

This emitter also constitutes the output U for the circuit 1 whereon the voltage value Vout, corresponding to the desired threshold voltage Vth, becomes available.

Thus, a ground-referred threshold voltage is generated, but nothing forbids said threshold voltage from being tied to the value of the supply voltage Vd. This can be accomplished simply by connecting the series of the transistor-diodes QD1, QD2 and output resistor R to the supply Vd rather than to ground 5, using pnp transistors.

The operation of the inventive generator will now be described.

Designated Vov, the overdrive voltage, is here below the difference between the gate-source voltage drop across the MOS transistors M1, M2 and the threshold voltage Vth, i.e. Vov=(Vgs-Vth).

The current flowing through a MOS transistor operated in the saturation range is given by the relation:

$$Io = [\mu o\ Cox/(1 + Q\ Vov)]\ (W/L)\ Vov^2\ (1 + I\ V_{DS}) \quad (1)$$

where, $\mu o$, Cox are characteristic parameters of the transistor, W and L are the width and length of the channel region, Q is a parameter accounting for the mobility of the charge carriers, and I accounts for channel length modulation, the two last-mentioned ones being second-order effects.

The instance of I = Q = 0 will be considered first.

The value of the $\alpha$ parameter is defined by a relation between the ratii (W/L) of each of transistors M1 and M2, namely by:

$$(W/L)_2 = \alpha^2\ (W/L)_1 \quad (2)$$

where $\alpha$ is equal 1.5-2.

The currents flowing through transistors M1 and M2 are the same and entirely due to the contribution from each corresponding generator Id. By virtue of the circuit networks composed of transistors Q1a, Q1b; Q2a, Q2b; Q3a, Q3b; Q4a, Q4b; no current will enter the circuit nodes A and B.

Accordingly, the relation between the overdrive voltages Vov of the two transistors M1, M2 may be expressed as follows from (2):

$$Vov_1 = \alpha\ Vov_2 \quad (3)$$

whence,

$$V2-V1 = \alpha(Vov_2+Vth) - (Vov_1+Vth) = (\alpha-1)Vth \quad (4)$$

allowing an output voltage Vout to be obtained on the output U which is equal to the desired threshold voltage Vth.

It matters to observe that both transistors M1 and M2 have the source connected to the potential 5, i.e. to ground, which prevents the so-called "body" effect from occurring.

When the second-order effects are also considered which are due to the mobility of the carriers, as brought about by the overdrive effect, and to the channel length modulation brought about by Vds (Q and I parameters), the error percent in obtaining the threshold voltage Vth can be estimated.

Taking the two currents flown through transistors M1 and M2 as identical with each other, relation (3) for the overdrive voltage may be re-stated as follows:

$$Vov_1 = \alpha\ Vov_2 + (1/2)(Q - I)(\alpha-1)\ Vov_2^2 \quad (5)$$

Therefore, (4) will become:

$$V_2-V_1 = (\alpha-1)[Vth + (1/2)(Q - I)\ Vov_2^2] \quad (6)$$

The term in square brackets is the error due to mobility and channel length modulation. Accordingly, the error percent E% of the error in determining the threshold voltage is given by:

$$E\% = 100\ (1/2)(Q - I)(Vgs_2 - Vth)^2/ Vth \quad (7)$$

which can be made smaller than 0.5%.

Reverting to the example of Figure 2, the network comprising the first cell and the transistor M1 carries out the voltage-to-current conversion of the threshold voltage plus the overdrive voltage of the first MOS transistor M1.

Likewise, the second cell and second MOS transistor M2 carry out the voltage-to-current conversion of $Vth + Vov_2$.

The provision of the current-mirrors 6 and 7 ensures both high accuracy and high output impedance.

Through the legs of the first cell (Q1a,Q1b), a current $I1 = Vgs_1/R$ will flow, and a current $I2 = Vgs_2/R$ will flow through the legs of the second cell (Q3a,Q3b).

Transistor Q5 mirrors current I1 exactly, whilst transistor Q6 mirrors a current $\alpha$ I2, due to its dimensions.

As a result, the output resistor $R_{out}$ connected in series with transistors QD1 and QD2 will have a current Iout flown therethrough which is given by:

$$Iout = \alpha\, I2 - I1 = (1/R)(\alpha\, Vgs_2 - Vgs_1) = Vth(\alpha - 1)/R$$

Thus, by selecting an output resistance Rout with a value of $R/(\alpha - 1)$, Vout can be accurately made equal to Vth.

The voltage generator of this invention has shown to be well capable of operating at room temperature with an error below 2% for each value of the voltage supply in excess of 3.5 Volts.

This circuit, moreover, is definitely to be preferred over those liable to the so-called "body" effect.

## Claims

1. A threshold voltage generator for a field-effect transistor, being of a type effective to compensate for variations in the threshold voltage from a nominal value comprising:

   first and second current generators (Id) connected to a reference potential (5) via respective transistors (M1, M2);

   a first amplifier (2) having a first input node (A) connected to said first current generator (Id);

   and characterized in that it comprises:

   a second amplifier (3) connected ahead of a second input node (B) of the first amplifier (A) and having an input connected to said second current generator (Id);

   the first input node (A) of the first amplifier (2) and the input of the second amplifier (3) being thus connected to said reference potential (5) via respective transistors (M1,M2);

   a third amplifier (4) connected after the first amplifier (2) and having an output (U) adapted to produce the value of said threshold voltage (Vth).

2. A voltage generator according to Claim 1, characterized in that said transistors (M1,M2) are field-effect transistors.

3. A voltage generator according to Claim 2, characterized in that said transistors (M1,M2) are arranged in a diode configuration.

4. A voltage generator according to Claim 1, characterized in that said second amplifier (3) has a gain whose value is given by a predetermined $\alpha$ parameter, whilst said third amplifier (4) has a gain which is defined by the $1/(\alpha-1)$ ratio.

5. A voltage generator according to Claims 2 and 4, characterized in that said $\alpha$ parameter is tied to the dimensions of the channel region of said transistors in accordance with the relation: $(W/L)2 = \alpha 2(W/L)1$, where W and L are the width and length, respectively, of the channel region.

6. A voltage generator according to Claim 1, characterized in that said second amplifier (3) is a bipolar transistor.

## Patentansprüche

1. Schwellenspannungsgenerator für einen Feldeffekttransistor, der gemäß seinem Typ die Wirkung hat, Abweichungen der Schwellenspannung von einem Nennwert zu kompensieren, umfassend:

   - einen ersten und einen zweiten Stromgenerator (Id), die über zugehörige Transistoren (M1, M2) an ein Referenzpotential (5) angeschlossen sind;

   - einen ersten Verstärker (2) mit einem ersten Eingangsknoten (A), der an den ersten Stromgenerator (Id) angeschlossen ist;

   **gekennzeichnet durch**

   - einen zweiten Verstärker (3), der einem zweiten Eingangsknoten (B) des ersten Verstärkers (A) vorgeschaltet ist und mit einem Eingang an den zweiten Stromgenerator (Id) angeschlossen ist;

   - wobei der erste Eingangsknoten (A) des ersten Verstärkers (2) und der Eingang des zweiten Verstärkers (3) somit über zugehörige Transistoren (M1, M2) an das Referenzpotential (5) angeschlossen sind;

- einen dritten Verstärker (4), der dem ersten Verstärker (2) nachgeschaltet ist und an einem Ausgang (U) den Wert der Schwellenspannung (Vth) zu erzeugen vermag.

2. Spannungsgenerator nach Anspruch 1, **dadurch gekennzeichnet**, daß die Transistoren (M1, M2) Feldeffekttransistoren sind.

3. Spannungsgenerator nach Anspruch 2, **dadurch gekennzeichnet**, daß die Transistoren (M1, M2) in Diodenschaltung angeordnet sind.

4. Spannungsgenerator nach Anspruch 1, **dadurch gekennzeichnet**, daß der zweite Verstärker (3) einen Verstärkungsgrad besitzt, dessen Wert durch einen vorbestimmten Parameter $\alpha$ gegeben ist, während der dritte Verstärker (4) einen Verstärkungsgrad besitzt, der durch das Verhältnis $1/(\alpha-1)$ definiert ist.

5. Spannungsgenerator nach Anspruch 2 und 4, **dadurch gekennzeichnet**, daß der Parameter $\alpha$ mit den Abmessungen der Kanalzone der Transistoren nach Maßgabe der Beziehung $(W/L)2=\alpha2(W/L)1$ verknüpft ist, wobei W und L die Breite bzw. die Länge der Kanalzone ist.

6. Spannungsgenerator nach Anspruch 1, **dadurch gekennzeichnet**, daß der zweite Verstärker (3) ein Bipolartransistor ist.

**Revendications**

1. Générateur de tension de seuil pour un transistor à effet de champ, d'un type propre à compenser des variations de la tension de seuil à partir d'une valeur nominale, comprenant :

- des premier et second générateurs de courant (Id) reliés à un potentiel de référence (5) par l'intermédiaire de transistors respectifs (M1, M2) ;
- un premier amplificateur (2) ayant un premier noeud d'entrée (A) relié audit premier générateur de courant (Id) ;

et caractérisé en ce qu'il comprend :

- un deuxième amplificateur (3), monté avant un second noeud d'entrée (B) du premier amplificateur (2) et ayant une entrée reliée audit second générateur de courant (Id) ;
- le premier noeud d'entrée (A) du premier amplificateur (2) et l'entrée du deuxième amplificateur (3) étant donc reliés audit potentiel de référence (5) par l'intermédiaire des transistors respectifs (M1, M2) ;
- un troisième amplificateur (4), monté après le premier amplificateur (2) et ayant une sortie (U) propre à produire la valeur de ladite tension de seuil (Vth).

2. Générateur de tension selon la revendication 1, caractérisé en ce que lesdits transistors (M1, M2) sont des transistors à effet de champ.

3. Générateur de tension selon la revendication 2, caractérisé en ce que lesdits transistors (M1, M2) sont montés en diode.

4. Générateur de tension selon la revendication 1, caractérisé en ce que ledit deuxième amplificateur (3) a un gain dont la valeur est donnée par un paramètre a prédéterminé, tandis que ledit troisième amplificateur (4) a un gain qui est défini par le rapport $1/(a-1)$.

5. Générateur de tension selon les revendications 2 et 4, caractérisé en ce que ledit paramètre a est lié aux dimensions de la zone du canal desdits transistors selon la relation : $(W/L)2 = a2(W/L)1$, où W et L sont, respectivement, la largeur et la longueur de la zone du canal.

6. Générateur de tension selon la revendication 1, caractérisé en ce que ledit deuxième amplificateur (3) est un transistor bipolaire.

EP 0 565 806 B1

FIG. - 1

FIG. - 2

FIG. - 3

EP 0 565 806 B1